# EUROPÄISCHE PATENTANMELDUNG

(11) **EP 2 674 770 A1**
(43) Veröffentlichungstag der Anmeldung: **18.12.2013**
(21) Anmeldenummer: 12171997.5
(22) Anmeldetag: 14.06.2012
(51) Int. Cl.: G01R 31/28

(54) **Vorrichtung und Verfahren zum Prüfen von elektronischen Bauteilelementen auf einem Träger oder einem Substrat**

(71) Anmelder: Multitest elektronische Systeme GmbH, 83026 Rosenheim (DE)
(72) Erfinder: Nagy, Andreas, 81549 München (DE); Killermann, Peter, 85560 Ebersberg (DE); Seguna, Charles, 83043 Bad Aibling (DE); Kerschl, Thomas, 83533 Edling (DE); Köhler, Michael, 83022 Rosenheim (DE); Minwegen, Jochen, 83043 Bad Aiblingen (DE)
(74) Vertreter: Dilg, Haeusler, Schindelmann Patentanwaltsgesellschaft mbH

(57) **Zusammenfassung**

Die Erfindung geht aus von einer Vorrichtung zum Prüfen von elektronischen Bauteilelementen (9, 10) auf einem Träger (7) oder einem Substrat (13) mit einer Positionier- und Halteeinrichtung (6) für den Träger (7) oder das Substrat (13), mit einem Testkopf (1) und einem damit verbundenen Prüfsockel (3, 14), mit dem gleichzeitig mehrere elektronische Bauteilelemente (9) auf dem Träger (7) oder dem Substrat (13) kontaktierbar sind. Erfindungsgemäß ist mit dem Testkopf (1) wenigstens ein weiterer Prüfsockel (4, 12) verbunden.

## Beschreibung

Die Erfindung betrifft eine Vorrichtung und ein Verfahren zum Prüfen von elektronischen Bauteilelementen auf einem Träger oder einem Substrat nach dem Oberbegriff von Anspruch 1 bzw. nach dem Oberbegriff von Anspruch 7.

Elektronische Bauteilelemente werden üblicherweise nach ihrer Herstellung bestimmten Tests unterzogen, um ihre elektrischen und/oder sensorischen Funktionen zu überprüfen. Hierzu wird eine Vielzahl der elektronischen Bauteilelemente auf einem Träger befestigt. Dieser Träger wird dann einem sogenannten Handler übergeben und in diesem exakt positioniert.

Sollen die Bauteilelemente geprüft werden bevor sie vereinzelt werden, also bevor das Substrat, auf dem sie hergestellt wurden entsprechend gesägt wurde, so wird anstatt eines Trägers mit bereits vereinzelten Bauteilelementen ein ganzer Substratstreifen an den Handler übergeben und in diesem positioniert.

Der Handler weist einen feststehenden Testkopf auf, mit dem ein ebenfalls feststehender Prüfsockel verbunden ist. Für elektrische Tests ist der Prüfsockel so ausgeführt, dass alle elektronischen Bauteilelemente auf dem Träger oder dem Substrat gleichzeitig kontaktiert und geprüft werden können. Dies ist auch bei sehr kleinen Bauteilelementen möglich, die in hoher Packungsdichte auf dem Träger aufgebracht sind.

Sollen aber beispielsweise Magnetsensoren getestet werden, müssen über den Magnetsensoren rotierende, sich nicht gegenseitig beeinflussende Magnetfelder erzeugt und die elektrische Reaktion der Magnetsensoren überprüft werden. Die Erzeugung der Magnetfelder ist aber nicht mit der Dichte möglich, die der Packungsdichte auf dem Träger oder dem Substrat entspricht. Der Prüfsockel kontaktiert deshalb in diesem Fall nur immer einen Teil der Bauteilelemente und prüft nur die momentan kontaktierte Gruppe gleichzeitig.

Erst nach Abschluss dieses Prüfschritts wird die nächste Gruppe kontaktiert und getestet. Es kann vorkommen, dass nur jeder vierte Magnetsensor auf dem Träger oder dem Substrat gleichzeitig getestet werden kann, so dass vier Prüfschritte durchgeführt werden müssen um alle Bauteilelemente auf dem Träger oder dem Substrat prüfen zu können.

Gegenüber dem Prüfsockel ist ein sogenanntes Nest vorgesehen, in das der Träger oder das Substrat positionsgenau eingelegt wird. Das Nest ist in x-, y-und z-Richtung bewegbar. Der Träger oder das Substrat kann auf diese Weise immer so positioniert werden, dass die für die anstehende Messung zu kontaktierenden elektronischen Bauteilelemente dem Prüfsockel gegenüber positioniert sind. Dann kann das Nest mit dem Träger oder dem Substrat mit den zu prüfenden Bauteilelementen mit vorbestimmter Kraft gegen den Prüfsockel gedrückt und so zwischen den Kontakte der Bauteilelemente und den Prüfnadeln des Prüfsockels eine elektrisch leitende Verbindung hergestellt werden.

Die bereits angesprochenen Magnetsensoren müssen aber nicht nur auf ihre magnetische, sondern auch auf ihre elektrische Funktion hin getestet werden. Dieser elektrische Test könnte für alle elektronischen Bauteilelemente auf dem Träger oder dem Substrat gleichzeitig ausgeführt werden. Da der Prüfsockel aber nur mit Prüfnadeln für eine Gruppe der Bauteilelemente auf dem Träger oder dem Substrat ausgestattet ist, kann auch die elektrische Prüfung nur gruppenweise durchgeführt werden. Hierdurch ergeben sich enorme Zeitverluste.

Um diese Zeitverluste zu vermeiden wurde auch bereits ein zweiter Handler verwendet. Das bedeutet, dass die elektronischen Bauteilelemente auf dem Träger in einem ersten Handler der magnetischen Prüfung unterzogen, dann in einen zweiten Handler überführt und dort der elektrischen Prüfung unterzogen werden. Hierdurch ergeben sich jedoch erhöhte Investitionskosten durch den zweiten Handler und ein Zeitverlust durch die Überführung des Trägers.

Diese Problematik gilt sowohl für elektronische Bauteilelemente auf einem Träger, als auch für Bauteilelemente, die sich noch auf dem Substrat befinden. Es spielt dabei keine Rolle, ob es sich um die Endprüfung für bereits fertiggestellte Bauteilelemente auf dem Substrat, oder aber um eine Zwischenprüfung für Bauteilelemente handelt, die noch nicht fertiggestellt sind und auf die nach der Zwischenprüfung noch weitere Bauteile aufgesetzt werden.

Der Erfindung liegt die Aufgabe zugrunde, eine Vorrichtung bzw. ein Verfahren zum Prüfen von elektronischen Bauteilelementen auf einem Träger oder einem Substrat so auszugestalten, dass die Zeitverluste reduziert werden können, ohne hohe Investitionskosten für einen zweiten Handler zu verursachen.

Gelöst wird die Aufgabe gemäß der Erfindung durch eine Vorrichtung bzw. ein Verfahren zum Prüfen von elektronischen Bauteilelementen auf einem Träger oder einem Substrat mit den Merkmalen von Anspruch 1 bzw. den Merkmalen von Anspruch 7.

Erfindungsgemäß ist mit dem Testkopf wenigstens ein weiterer Prüfsockel verbunden. Es wird dadurch möglich innerhalb des gleichen Handlers eine zweite Prüfung durchzuführen, die mit dem Prüfsockel für die erste Prüfung nicht möglich ist oder nur mit erheblichem Zeitverlust durchgeführt werden könnte. Die Positionier- und Halteeinrichtung für den Träger oder das Substrat verändert die Position des Trägers oder Substrats dabei nach der ersten Prüfung so, dass elektronische Bauteilelemente auf dem Träger oder dem Substrat mit dem weiteren Prüfsockel kontaktiert werden können.

Weitere Einzelheiten und Vorteile der Erfindung ergeben sich aus den Unteransprüchen.

Bei einem vorteilhaften Ausführungsbeispiel der Erfindung ist der weitere Prüfsockel so ausgestaltet, dass damit ein einzelnes elektronisches Bauteilelement auf dem Träger oder dem Substrat kontaktierbar ist. Hierdurch ergibt sich ein enormer Vorteil, wenn bei einer ersten Prüfung ein elektronisches Bauteilelement ein Testergebnis zeigt, welches eigentlich darauf hindeutet, dass das getestete Bauteilelement nicht in Ordnung ist, aber auch die Möglichkeit offen lässt, dass während der Prüfung lediglich die Kontaktierung zwischen Bauteilelement und Prüfsockel nicht ganz in Ordnung war. Solche Probleme können beispielsweise durch Staub hervorgerufen werden.

Durch die Erfindung kann das Bauteilelement nun mit dem weiteren Prüfsockel erneut geprüft werden, ohne dass dabei die bereits für gut befundenen Bauteilelemente erneut mit Prüfnadeln kontaktiert werden müssen. Diese erneute Kontaktierung soll auf jeden Fall vermieden werden, da jede Kontaktierung mit hohen Kräften durchgeführt wird und bei einer erneuten Kontaktierung Schäden bei einem bereits für gut befundenen Bauteilelement auftreten könnten. Die als nicht in Ordnung befundenen Bauelemente wurden aus diesem Grund bisher als Abfall entsorgt, auch wenn bei der Prüfung nur ein Kontaktfehler vorlag.

In einem anderen Ausführungsbeispiel ist der weitere Prüfsockel so ausgestaltet, dass damit mehrere elektronische Bauteilelemente auf dem Träger oder dem Substrat gleichzeitig kontaktierbar sind. Dieses Ausführungsbeispiel kommt beispielsweise dann zur Anwendung, wenn bei einer ersten Prüfung nur eine Gruppe von Bauteilelementen gleichzeitig geprüft werden kann. Z. B. müssen die Bauteilelemente auf dem Träger oder dem Substrat in vier Schritten der ersten Prüfung unterzogen werden. Bei der zweiten Prüfung mit dem weiteren Sockel kann die Prüfung beispielsweise in zwei Schritten durchgeführt werden. Auch bei diesem Ausführungsbeispiel ergibt sich eine Zeitersparnis gegenüber einem Handler, in dem auch die zweite Prüfung mit dem Prüfsockel der ersten Prüfung in vier Schritten durchgeführt werden müsste.

Sollen beispielsweise Magnetsensoren auf ihre Empfindlichkeit gegenüber einem Magnetfeld und auf ihre elektronischen Eigenschaften hin untersucht werden, kommt ein weiteres Ausführungsbeispiel der Erfindung zur Anwendung. Da bei der magnetischen Prüfung nur ein Prüfsockel mit geringerer Packungsdichte von Magnetfeldgeneratoren als der Packungsdichte von Bauteilelemente auf dem Träger oder dem Substrat möglich ist, muss diese Prüfung in mehreren Schritten durchgeführt werden. Dagegen kann bei der elektronischen Prüfung der weitere Prüfsockel so dicht mit Prüfnadelgruppen für die einzelnen Bauteilelemente gepackt sein, wie Bauteileelemente auf dem Träger oder dem Substrat vorhanden sind. Es ist deshalb mit dem Prüfsockel für die magnetische Prüfung nur ein Teil der elektronischen Bauteilelemente auf dem Träger oder dem Substrat gleichzeitig kontaktierbar, während mit dem weiteren Prüfsockel alle elektronischen Bauteilelemente auf dem Träger oder Substrat gleichzeitig kontaktierbar sind.

Um Zeit einsparen zu können, sollte vermieden werden, dass der Träger oder das Substrat nach der ersten Prüfung mit dem Prüfsockel in eine zweite Positionier- und Halteeinrichtung überführt werden muss. Die vorhandene Positionier- und Halteeinrichtung sollte deshalb so ausgebildet sein, dass der Träger oder das Substrat sowohl unter dem Prüfsockel als auch unter dem weiteren Prüfsockel für eine Kontaktierung positionierbar ist.

Es soll in jedem Fall vermieden werden, dass elektronische Bauteilelemente öfter als unbedingt notwendig kontaktiert werden, da die Kontaktierungen mit großem Druck durchgeführt werden müssen und die Gefahr einer Beschädigung des Bauteilelements nicht ausgeschlossen werden kann. Bei der zweiten Prüfung mit dem weiteren Prüfsockel ist deshalb darauf zu achten, dass nur die Bauteilelemente erneut kontaktiert werden, die tatsächlich der zweiten Prüfung unterzogen werden sollen. Das bedeutet auch, dass Elektronische Bauteilelemente nicht ein weiteres Mal von dem Prüfsockel für die erste Prüfung kontaktiert werden sollen. Die beiden Prüfsockel und die Positionier- und Halteeinrichtung müssen deshalb entsprechend aufeinander abgestimmt sein. Dementsprechend sind die beiden Prüfsockel so angeordnet, dass jedes elektronische Bauteilelement auf dem Träger oder dem Substrat von einem der Prüfsockel kontaktierbar ist, ohne dass dabei ein anderes Bauteilelement von dem anderen Prüfsockel kontaktiert wird.

Bei dem erfindungsgemäßen Verfahren werden zuerst alle elektronischen Bauteilelemente auf dem Träger oder dem Substrat von dem Prüfsockel kontaktiert, während danach wenigstens ein elektronisches Bauteilelement auf dem Träger oder dem Substrat von einem weiteren Prüfsockel kontaktiert und die Messdaten an den selben Testkopf weitergegeben werden. Durch diese Abfolge von Verfahrensschritten ist gewährleistet, dass die erste Prüfung abgeschlossen ist und die zweite Prüfung mit dem weiteren Prüfsockel sogar von dem Ergebnis der ersten Prüfung abhängig gemacht werden kann. Es wird auf diese Weise auch möglich, die zweite Prüfung sehr schnell im gleichen Handler durchzuführen.

Wie bereits oben erläutert, ist es z. B. bei der Prüfung von Magnetsensoren nicht möglich mit dem Prüfsockel alle Bauteilelemente auf dem Träger oder dem Substrat gleichzeitig zu kontaktieren, da die Erzeugung des für die Prüfung benötigten Magnetfelds mehr Platz benötigt als die elektrische Kontaktierung der Bauteilelemente. Um alle elektronischen Bauteilelemente auf dem Träger oder Substrat prüfen zu können, müssen die elektronischen Bauteilelemente auf dem Träger oder dem Substrat von dem Prüfsockel in mehreren Einzelschritten kontaktiert werden. Hierzu werden alle elektronischen Bauteilelemente auf dem Träger oder dem Substrat in Gruppen aufgeteilt und die elektronischen Bauteilelemente einer Gruppe von dem Prüfsockel jeweils gleichzeitig kontaktiert.

Insbesondere bei der Prüfung von Bauteilelementen, bei denen eine erste Prüfung in mehreren Prüfschritten durchgeführt werden muss, kann viel Zeit eingespart werden, wenn eine zweite notwendige Prüfung nicht mit dem selben Prüfsockel, wiederum in mehreren einzelnen Prüfschritten, sondern mit einem weiteren Prüfsockel in einem einzigen Prüfschritt durchgeführt werden kann. Zu diesem Zweck werden alle elektronischen Bauteilelemente auf dem Träger oder dem Substrat von dem weiteren Prüfsockel gleichzeitig kontaktiert.

Weitere Einzelheiten und Vorteile der Erfindung ergeben sich aus der Beschreibung eines Ausführungsbeispiels, das anhand der Zeichnung eingehend erläutert wird.

Es zeigt:
- Fig. 1: eine schematische Ansicht eines erfindungsgemäßen Handlers,
- Fig. 2: eine schematische Darstellung eines Tests von Bauteilelementen mit einem ersten Array-Prüfsockel in dem Handler nach Fig. 1,
- Fig. 3: eines Tests mit einem zweiten Array-Prüfsockel,
- Fig. 4: eine Ansicht eines weiteren erfindungsgemäßen Handlers,
- Fig. 5: eine Darstellung eines Tests von Bauteilelementen mit einem ersten Array-Prüfsockel in dem Handler nach Fig. 5 und
- Fig. 6: eines Test mit einem zweiten Einzel-Prüfsockel

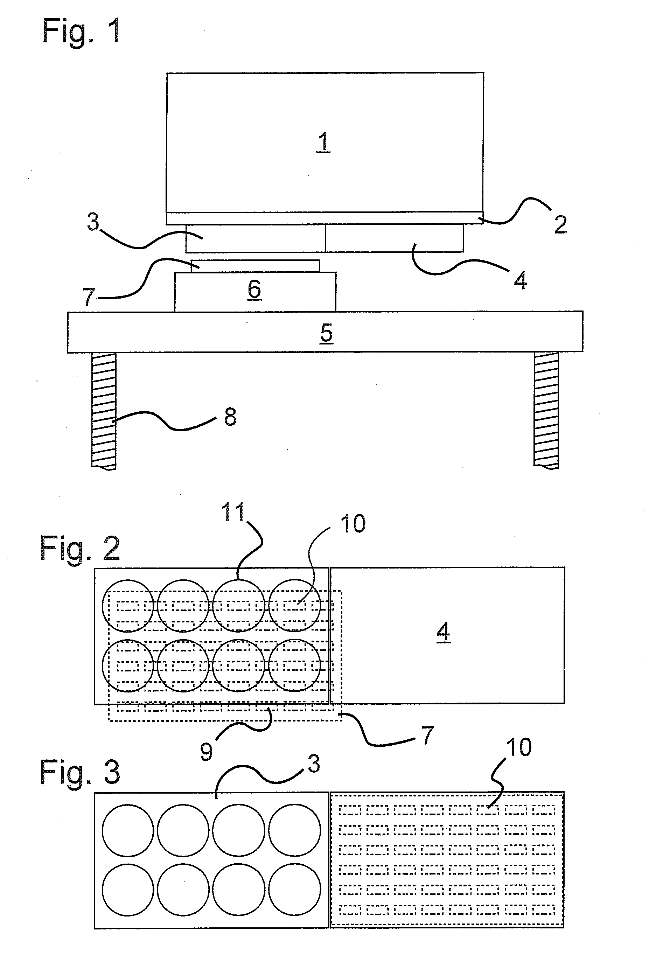

Der Handler nach Fig. 1 weist einen Druckstempel 5 auf, der mit Hilfe der Gewindestangen 8 gleichmäßig nach oben und unten bewegt werden kann. Auf dem Druckstempel ist das Nest 6 vorgesehen, welches die Aufnahme für den Träger 7 enthält und zusammen mit einer hier nicht dargestellten X-Y-Verschiebeeinrichtung die Positionier- und Halteeinrichtung für den Träger 7 bildet.

Mit Hilfe des Nests 6 kann der Träger hochgenau unterhalb des ersten Array-Prüfsockels 3 oder des zweiten Array-Prüfsockels 4 positioniert werden. Auf dem Träger sind die in den Figuren 2 und 3 dargestellten Bauteilelemente 9 und 10 befestigt.

In der Zeichnung sind die Bauteilelemente beispielsweise auf einem Träger angeordnet. Der Träger kann als Klemmträger ausgebildet sein, wie er beispielsweise in der WO 2009/100910 A1 beschrieben ist. Das Nest 6 kann aber auch mit einer Aufnahme für einen Substratstreifen versehen sein, wenn Bauteilelemente geprüft werden sollen, die noch nicht vereinzelt sind.

Über dem Druckstempel 5 und dem Nest 6 ist der Testkopf 1 als festes, unbewegliches Modul montiert. Die Verbindung zwischen dem Testkopf 1 und den Prüfsockeln 3 und 4 wird durch das Loadboard 2 geschaffen.

Zum Prüfen der Bauteilelemente wird der Druckstempel 5 nach oben gefahren und und die Kontakte der Bauteilelemente mit großer Kraft gegen die Prüfnadeln der Prüfsockel 3 und 4 gedrückt. Sollen Bauteilelemente auf einem Substrat geprüft werden, kontaktieren die Prüfnadeln üblicherweise Kontaktflächen auf dem Substrat, die den Bauteilelementen gegenüber angeordnet sind.

In dem in den Figuren 1 bis 3 gezeigten Ausführungsbeispiel sollen Magnetsensoren auf einem Klemmträger geprüft werden. Hierzu müssen sowohl die Empfindlichkeit gegenüber einem Magnetfeld, als auch die elektronischen Eigenschaften geprüft werden. In dem ersten Prüfsockel 3 sind deshalb acht Magnetfeldgeneratoren 11 angeordnet, die jeweils ein rotierendes Magnetfeld erzeugen.

Wie aus Fig. 2 zu entnehmen ist, benötigen die Magnetfeldgeneratoren 11 relativ viel Platz, so dass nicht alle auf dem Träger 7 gehaltenen Bauteilelemente 9 gleichzeitig geprüft werden können. In der in Fig. 2 gezeigten Stellung können nur die jeweils in der Mitte der Magnetfeldgeneratoren 11 zu sehenden Bauteilelemente 10 geprüft werden.

Hierzu wird der Druckstempel nach oben verfahren, so dass die Kontakte der dieser Gruppe von acht Bauteilelementen 10 gegen die Prüfnadeln des ersten Prüfsockels 3 gedrückt werden. Dann werden die Magnetfeldgeneratoren 11 in Betrieb gesetzt und die resultierenden Signale an den Testkopf 1 weitergeleitet.

Ist der Prüfschritt für diese Gruppe von Bauteilelementen 9 abgeschlossen, wird der Druckstempel 5 wieder nach unten gefahren und der Träger 7 auf dem Nest 6 neu positioniert, so dass acht andere Bauteilelemente geprüft werden können. Um die Positionierzeit möglichst kurz halten zu können, ist es sinnvoll, für die jeweils nächste Prüfung eine Gruppe von Bauteilelementen auszuwählen, die direkt neben den bereits geprüften angeordnet sind. So kann beispielsweise für den zweiten Prüfschritt das Nest 6 mit dem Träger 7 soweit nach links verschoben werden, dass jeweils die Bauteilelemente rechts von den bereits Geprüften in der Mitte der Magnetfeldgeneratoren 11 zu liegen kommt. Für den dritten Prüfschritt wird der Träger 7 dann nach oben und für den vierten Prüfschritt nach rechts verschoben.

In dem hier gezeigten Beispiel sind sechs Prüfschritte nötig, bis alle Bauteilelemente 9 auf dem Träger 7 geprüft sind. Danach muss nur noch die elektronische Prüfung mit dem zweiten Prüfsockel 4 in einem Schritt durchgeführt werden. Hierzu wird das Nest 6 mit dem Träger 7 unter dem zweiten Prüfsockel 4 positioniert. Da die Prüfnadeln in dem Prüfsockel genauso eng gepackt werden können wie die Kontakte der Bauteilelemente 9 auf dem Träger, ist die elektronische Prüfung in einem einzigen Schritt möglich.

Gegenüber bekannten Handlern mit nur einem Prüfsockel lässt sich durch diese Maßnahme viel Zeit einsparen. Bei diesen bekannten Handlern musste die elektronische Prüfung ebenfalls mit dem ersten Prüfkopf durchgeführt werden. Hierfür waren, wie bei der magnetischen Prüfung, ebenfalls 6 einzelne Prüfschritte notwendig. Geht man davon aus, dass für die elektronische Prüfung etwa 10 sec benötigt werden, so wird für diese Prüfung mit dem ersten Prüfkopf eine Zeitspanne von 60 sec benötigt, da von den 48 Bauteilelementen auf dem Träger 7 immer nur 8 Bauteilelemente gleichzeitig gemessen werden können und somit sechs Messvorgänge nötig sind.

Mit dem erfindungsgemäßen zweiten Prüfsockel 4 können dagegen alle Bauteilelemente gleichzeitig in 10 sec geprüft werden. Kalkuliert man für die Neupositionierung unter dem zweiten Prüfsockel 4 nochmals 2 sec ein, so ergibt sich für die Prüfung aller auf dem Träger 7 angeordneten Bauteilelemente 9 eine Zeitersparnis von etwa 48 sec.

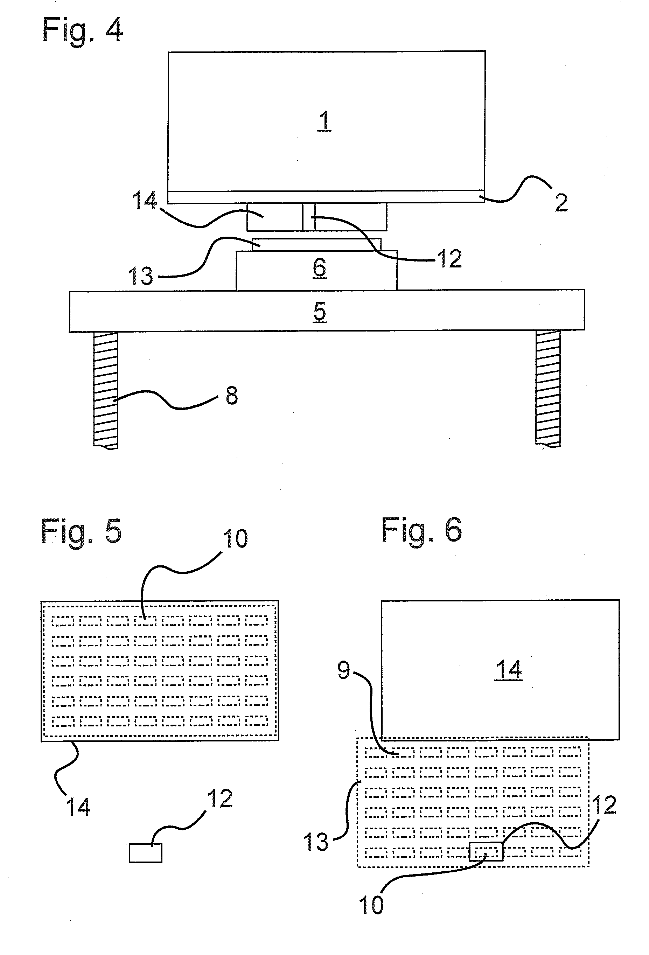

Eine weitere Anwendung der Erfindung ist in dem Ausführungsbeispiel nach den Figuren 4 bis 6 gezeigt. Hier ist ein zweiter Prüfsockel als Einzel-Prüfsockel 12 ausgeführt. Ansonsten gleiche Teile sind auch mit gleichen Bezugszeichen wie in den Figuren 1 bis 3 versehen.

Bei diesem Ausführungsbeispiel ist als erster Prüfsockel ein Prüfsockel 14 für den elektronischen Test vorgesehen, der dem zweiten Prüfsockel 4 aus dem Ausführungsbeispiel nach den Figuren 1 bis 3 entspricht. Der zweite Prüfsockel 12 ist dagegen ein Prüfsockel, der nur ein einziges Bauteilelement kontaktiert.

Bei der elektronischen Prüfung von elektronischen Bauteilelementen kommt es immer wieder vor, dass ein Bauteilelement als nicht in Ordnung klassifiziert wird, obwohl eigentlich alle erforderlichen Funktionen erfüllt werden. Dies ergibt sich oftmals aus Kontaktierungsproblemen, die beispielsweise von Staubkörnern verursacht werden können. Solche Bauteilelemente wurden bisher als Ausschuss entsorgt.

Eine Wiederholung der elektronischen Prüfung hätte bedeutet, dass alle für gut befundenen Bauteilelemente ebenfalls ein zweites Mal hätten kontaktiert werden müssen, was - wie oben bereits beschrieben - zu Beschädigungen der als gut getesteten Bauteilelemente führen kann.

Sind die Bauteilelemente nicht auf einem Substrat sondern auf einem Träger, beispielsweise einem Klemmträger angeordnet, bestünde auch die Möglichkeit, als schlecht getestete Bauteilelemente zu separieren, auf einem anderen Klemmträger zu platzieren und dann nur die als schlecht getesteten Bauteilelemente einer erneuten Prüfung zu unterziehen. In diesem Fall wäre aber eine Verpackung entsprechend der Produktions-Chargen äußerst aufwendig, da die zweitgeprüften Bauteilelemente jeweils wieder mit den Erstgeprüften zusammengeführt werden müssten.

In beiden Fällen hätten sich Nachteile ergeben, die in keinem Verhältnis zu den evtl. eingesparten Kosten standen. Es wurden daher alle Bauteilelemente, die bei der ersten Prüfung als schlecht getestet wurden, aussortiert und entsorgt.

Mit dem Handler nach Fig. 4 können solche Verluste auf einfache Weise und mit geringem Aufwand vermieden werden. Das Substrat 13 mit den Bauteilelementen 9 ist auf dem Nest so platziert und gehalten, dass sich die Bauteilelemente 9 an der Unterseite des Substrats 13 befinden. Die Kontaktflächen sind dagegen auf der Oberseite des Substrats 13 angeordnet. Selbstverständlich könnte das Nest 6 bei diesem Ausführungsbeispiel aber auch so ausgeführt sein, dass ein mit elektronischen Bauteilelementen bestückter Träger gehalten werden kann. In beiden Fällen sind die Vorteile, die sich durch den zusätzlichen Einzel-Prüfsockel 12 ergeben, die gleichen.

Zur Prüfung der Bauteilelemente 9 wird nun das Nest 6 unter dem Array-Prüfsockel 14 für die elektrische Prüfung positioniert und festgehalten. Beim Hochfahren des Druckstempels 5 werden die Kontaktflächen aller Bauteilelemente 9 gleichzeitig mit den Prüfnadeln des Prüfsockels 14 in Kontakt gebracht. Es können alle Bauteilelemente 10 auf diese Weise parallel getestet werden. Wenn bei dieser Prüfung keine Fehler festgestellt werden, ist diese Prüfung beendet und die geprüften Bauteilelemente können weiter verarbeitet werden.

Wird jedoch bei einem Bauteilelement ein Fehler festgestellt, wird der Druckstempel 5 nach unten gefahren und das Nest 6 wird so positioniert, dass sich das als fehlerhaft getestete Bauteilelement 10 unter dem Einzel-Prüfsockel 12 befindet. Der Druckstempel 5 wird wieder nach oben gefahren und die diesem Bauteilelement 10 zuzuordnenden Kontaktflächen des Substrats 13 auf die Prüfnadeln des Einzel-Prüfsockels 12 gedrückt.

Verläuft diese erneute Prüfung ebenfalls negativ, so wird das Bauteilelement als fehlerhaft klassifiziert und nach der Vereinzelung entsorgt. Im anderen Fall werden alle auf dem Substrat angeordneten Bauteilelemente 9 weiterverarbeitet.

Sollte bei einer Reihe von geprüften Substraten 13 immer an dem gleichen Bauteilelement bei der ersten Prüfung ein Fehler festgestellt werden, bei der zweiten Prüfung mit dem Einzel-Prüfsockel 12 das Bauteilelement aber für gut befunden werden, ist davon auszugehen, dass der Array-Prüfsockel 14 für die erste Prüfung defekt ist. In diesem Fall müssen die betroffenen Prüfnadeln einer Reinigung unterzogen oder ausgetauscht werden.

Ein zusätzlicher Einzel-Prüfsockel 12 ist also immer dann sinnvoll, wenn bei dem durchzuführenden Test mehrere Bauteilelemente gleichzeitig geprüft werden sollen. Es spielt dabei keine Rolle, ob das ganze Bauteilelemente-Array, eine Zeile oder Spalte davon, oder eine andere ausgewählte Gruppe von Bauteilelementen gleichzeitig getestet werden. Durch den zusätzliche Einzel-Prüfsockel 12 kann eine erneute Kontaktierung der bei der Prüfung für gut befundenen Bauteilelemente vermieden werden, so dass nur das Bauteilelement erneut kontaktiert werden muss, bei dem in der ersten Prüfung ein Fehler festgestellt wurde. Der Einzel-Prüfsockel 12 dient aber auch der schnellen Auffindung von Fehlern und Defekten an dem Array-Prüfsockel 14.

### Bezugszeichenliste:

- 1: Testkopf
- 2: Loadboard
- 3: erster Prüfsockel für Magnettest
- 4: zweiter Prüfsockel für elektronischen Test
- 5: Druckstempel
- 6: Nest
- 7: Träger
- 8: Gewindestangen
- 9: Bauteilelement
- 10: gleichzeitig zu prüfende Bauteilelemente
- 11: Magnetfeldgenerator
- 12: zweiter Prüfsockel für Einzeltest
- 13: Substrat
- 14: erster Prüfsockel für elektronischen Test

## Patentansprüche

1. Vorrichtung zum Prüfen von elektronischen Bauteilelementen (9) auf einem Träger (7) oder einem Substrat (13) mit einer Positionier- und Halteeinrichtung (6) für den Träger (7) oder das Substrat (13), mit einem Testkopf (1) und einem damit verbundenen Prüfsockel (3, 14), mit dem gleichzeitig mehrere elektronische Bauteilelemente (10) auf dem Träger (7) oder dem Substrat (13) kontaktierbar sind, **dadurch gekennzeichnet, dass** mit dem Testkopf (1) wenigstens ein weiterer Prüfsockel (4, 12) verbunden ist.

2. Vorrichtung nach Anspruch 1 **dadurch gekennzeichnet, dass** der weitere Prüfsockel (12) so ausgestaltet ist, dass damit ein einzelnes elektronisches Bauteilelement (10) auf dem Träger (7) oder dem Substrat (13) kontaktierbar ist.

3. Vorrichtung nach Anspruch 1, **dadurch gekennzeichnet, dass** der weitere Prüfsockel (4) so ausgestaltet ist, dass damit mehrere elektronische Bauteilelemente (10) auf dem Träger (7) oder dem Substrat (13) gleichzeitig kontaktierbar sind.

4. Vorrichtung nach einem der Ansprüche 1 und 3, **dadurch gekennzeichnet, dass** mit dem Prüfsockel (3) ein Teil der elektronischen Bauteilelemente (10) auf dem Träger (7) oder dem Substrat (13) und mit dem weiteren Prüfsockel (4) alle elektronischen Bauteilelemente (10) auf dem Träger (7) oder Substrat (13) gleichzeitig kontaktierbar sind.

5. Vorrichtung nach einem der Ansprüche 1 bis 4, **dadurch gekennzeichnet, dass** die Positionier- und Halteeinrichtung (6) so ausgebildet ist, dass der Träger (7) oder das Substrat (13) sowohl unter dem Prüfsockel (3, 14) als auch unter dem weiteren Prüfsockel (4, 12) für eine Kontaktierung positionierbar ist.

6. Vorrichtung nach einem der Ansprüche 1 bis 5 , **dadurch gekennzeichnet, dass** die beiden Prüfsockel (3, 4; 14, 12) so angeordnet sind, dass jedes elektronische Bauteilelement (9) auf dem Träger (7) oder dem Substrat (13) von einem der Prüfsockel (3, 4; 14, 12) kontaktierbar ist, ohne dass dabei ein anderes Bauteilelement (9) von dem anderen Prüfsockel (3, 4; 14, 12) kontaktiert wird.

7. Verfahren zum Prüfen von elektronischen Bauteilelementen (9) auf einem Träger (7) oder einem Substrat (13), bei dem mehrere elektronische Bauteilelemente (10) auf dem Träger (7) oder dem Substrat (13) gleichzeitig von einem Prüfsockel (3, 14) kontaktiert und Messdaten an einen Testkopf (1) weitergegeben werden, **dadurch gekennzeichnet, dass** zuerst alle elektronischen Bauteilelemente (10) auf dem Träger (7) oder dem Substrat (13) von dem Prüfsockel (3, 14) kontaktiert werden und danach wenigstens ein elektronisches Bauteilelement (10) auf dem Träger (7) oder dem Substrat (13) von einem weiteren Prüfsockel (4, 12) kontaktiert und Messdaten an den selben Testkopf (1) weitergegeben werden.

8. Verfahren nach Anspruch 7, **dadurch gekennzeichnet, dass** die elektronischen Bauteilelemente (9) auf dem Träger (7) oder dem Substrat (13) von dem Prüfsockel (3) in mehreren Einzelschritten kontaktiert werden, indem alle elektronischen Bauteilelemente (9) auf dem Träger (7) oder dem Substrat (13) in Gruppen aufgeteilt und die elektronischen Bauteilelemente (10) einer Gruppe von dem Prüfsockel (3) jeweils gleichzeitig kontaktiert werden.

9. Verfahren nach einem der Ansprüche 7 bis 8, **dadurch gekennzeichnet, dass** alle elektronischen Bauteilelemente (10) auf dem Träger (7) oder dem Substrat (13) von dem weiteren Prüfsockel (4) gleichzeitig kontaktiert werden.
